(19) **Europäisches Patentamt / European Patent Office / Office européen des brevets**

(11) **EP 3 667 914 B1**

(12) **FASCICULE DE BREVET EUROPEEN**

(45) Date de publication et mention de la délivrance du brevet: **17.03.2021 Bulletin 2021/11**

(51) Int Cl.: ***H03K 5/13*** *(2014.01)*

(21) Numéro de dépôt: **19214312.1**

(22) Date de dépôt: **06.12.2019**

(54) **CALIBRATION D'UN CIRCUIT RETARDATEUR**

KALIBRIERUNG EINES VERZÖGERUNGSSCHALTKREISES

CALIBRATION OF A DELAY CIRCUIT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.12.2018 FR 1872693**

(43) Date de publication de la demande:
**17.06.2020 Bulletin 2020/25**

(72) Inventeurs:
- **BILLIOT, Gérard**
  **38054 Grenoble Cedex 9 (FR)**
- **BADETS, Franck**
  **38054 Grenoble Cedex 9 (FR)**
- **MONNIER-BOURDIN, Dominique**
  **33114 Le Barp (FR)**
- **RIONDET, Bernard**
  **91430 Vauhallan (FR)**

(73) Titulaires:
- **Commissariat à l'Energie Atomique et aux Energies Alternatives**
  **75015 Paris (FR)**
- **Greenfield Technology**
  **91300 Massy (FR)**

(74) Mandataire: **Cabinet Beaumont**
**4, Place Robert Schuman**
**B.P. 1529**
**38025 Grenoble Cedex 1 (FR)**

(56) Documents cités:
JP-A- H04 215 314  US-A- 5 790 480
US-A1- 2016 373 120  US-A1- 2018 269 895

EP 3 667 914 B1

**Description**

Domaine technique

La présente description concerne de façon générale les circuits électroniques et, plus particulièrement, les circuits programmables de génération de retards asynchrones. La présente description concerne plus précisément les circuits basés sur des générateurs de rampe.

Technique antérieure

Dans de nombreuses applications, on souhaite disposer de retardateurs de signaux électroniques. Il peut s'agir, par exemple, de comparateurs de phase, de fonctions de synchronisation, de générateurs de signaux d'horloge, de circuits de transmission, etc. Le plus souvent, on souhaite également pouvoir programmer le retard, c'est-à-dire en ajuster la valeur. Par ailleurs, il est également généralement souhaitable de pouvoir garantir la relation entre une consigne fournie par l'application et la valeur du retard obtenu.

Les fonctions de génération d'un retard programmable fournissent généralement une impulsion au bout d'un certain temps suivant un évènement déclencheur. Ce temps définit la valeur du retard. La programmation du retard (consigne) peut prendre diverses formes analogiques ou numériques.

Les fonctions ou circuits à retard programmable peuvent se répartir en trois grandes catégories.

Une première catégorie concerne les solutions à base de compteurs numériques incrémentés au rythme d'un oscillateur. L'événement déclencheur est généralement une initialisation du compteur. L'impulsion de retard est déclenchée lorsque le compteur atteint un compte donné représentant la consigne.

Une deuxième catégorie concerne les solutions à base d'éléments retardateurs (le plus souvent des inverseurs logiques) montés en boucle à verrouillage de retard (DLL - Delay Locked Loop).

Une troisième catégorie concerne les solutions basées sur un générateur de rampe de tension à partir d'une charge de capacité. Dans ces solutions, une rampe de tension est obtenue par la charge d'une capacité à courant constant et l'impulsion de retard est générée lorsque la tension de la rampe atteint un seuil représentant la consigne.

La présente description concerne plus particulièrement cette troisième catégorie de retardateurs.

Le document US-A-2016/0373120 décrit une technique de calibration d'un convertisseur numérique-temporel.

Le document JP-A-04215314 décrit un circuit de retard variable.

Le document US 5,790,480 décrit un circuit de mesure de temps entre deux événements.

Le document US-A-2018/0269895 décrit un convertisseur numérique-temporel et son procédé de fonctionnement.

Résumé de l'invention

Il existe un besoin d'amélioration des retardateurs électroniques en termes de fiabilité de la relation entre une consigne d'un retard souhaité et la valeur du retard obtenu.

Il existe également un besoin d'amélioration des retardateurs électroniques en termes de résolution (écart entre deux valeurs consécutives du retard).

Un mode de réalisation pallie tout ou partie des inconvénients des circuits retardateurs usuels.

Un mode de réalisation prévoit un procédé de calibration d'un circuit de génération d'un retard, le circuit comportant :

- un élément capacitif d'intégration d'un premier courant fourni par une première source de courant, dans lequel la première source de courant comporte un premier convertisseur numérique-analogique commandé par un premier code numérique de commande ;
- un circuit d'initialisation de l'élément capacitif sur commande d'un signal d'initialisation ;
- un comparateur d'une première tension de charge dudit élément capacitif par rapport à une deuxième tension, ladite deuxième tension étant générée à partir d'un deuxième convertisseur numérique-analogique commandé par un deuxième code numérique de commande, le comparateur présentant une sortie de comparaison délivrant un signal de sortie présentant un retard souhaité par rapport au signal d'initialisation ; et

dans lequel, lors d'une phase d'utilisation du circuit de génération de retards, seul un code, dit code de sélection, parmi les premier et deuxième codes numériques de commande est utilisé pour sélectionner le retard souhaité, l'autre code de commande, dit code de réglage, restant à une valeur prédéfinie ; et

dans lequel, lors d'une phase de calibration du circuit de génération de retards, les premier et deuxième codes numériques de commande sont utilisés pour définir ladite valeur prédéfinie et la sortie de comparaison est reliée à une entrée d'un comparateur de phase ; et
dans lequel, le procédé de calibration comprend les étapes suivantes :

dans une première phase de test :

a1) appliquer un premier jeu de premier et deuxième codes numériques de commande et appliquer un signal d'initialisation ;
b1) délivrer sur une autre entrée du comparateur de phase, un signal de calibration présentant un premier délai de référence par rapport au signal d'initialisation ;
c1) analyser le signal de sortie du comparateur de phase ; et

dans une deuxième phase de test :

a2) appliquer un deuxième jeu de premier et deuxième codes numériques de commande et appliquer un signal d'initialisation ;
b2) délivrer, sur ladite autre entrée du comparateur, un signal de calibration présentant un délai égal à la somme du premier délai de référence et d'un deuxième délai de référence ;
c2) analyser le signal de sortie du comparateur de phase.

Selon un mode de réalisation, les première et deuxième phases de test sont réitérées plusieurs fois en changeant les premier et deuxième jeux de premier et deuxième codes numériques de commande, pour identifier ladite valeur prédéfinie du code de réglage.

Selon un mode de réalisation, la première phase de test est réitérée en changeant la valeur d'un même code parmi le code de sélection et le code de réglage, et la deuxième phase de test est réitérée en changeant la valeur de l'autre code.

Selon un mode de réalisation, une même phase de test, la première et/ou la deuxième, est réitérée plusieurs fois pour un même jeu de codes numériques de commande, les valeurs successives du signal de sortie de comparaison étant analysées ensemble pour déterminer si le jeu de codes numériques appliqué permet ou non d'obtenir un délai de retard sensiblement égal, selon la phase de test, au premier délai de référence ou à la somme des premier et deuxième délais de référence.

Selon un mode de réalisation, lors de la phase de test, réitérée en changeant la valeur du code de sélection, on recherche une première valeur extrémale du code de sélection et dans lequel, on définit une deuxième valeur extrémale du code de sélection à partir de la première valeur extrémale et d'un nombre de codes correspondant à une plage de codes de pleine échelle souhaitée ; et, lors de l'autre phase de test, réitérée en changeant la valeur du code de réglage, la valeur du code de sélection utilisée correspond à la deuxième valeur extrémale du code de sélection préalablement définie.

Selon un mode de réalisation, le deuxième délai de référence correspond à une pleine échelle de valeurs de délais souhaités pour lesquels la courbe représentant le délai de retard obtenu en fonction de la valeur de code de sélection, pour une valeur donnée de code de réglage, est sensiblement linéaire.

Selon un mode de réalisation, le procédé utilise un deuxième circuit de génération de retards identique audit circuit de génération de retards, dans lequel, lors des étapes b1) ou b2), le deuxième circuit de génération de retards est utilisé pour générer ledit signal de calibration en entrée du comparateur, le signal d'initialisation du deuxième circuit de génération de retards étant respectivement synchrone avec le signal d'initialisation du premier circuit de génération de retards ou différé d'un délai égal au deuxième délai de référence.

Un mode de réalisation prévoit un circuit comprenant un circuit de génération d'un retard, comportant :

- un élément capacitif d'intégration d'un premier courant fourni par une première source de courant, dans lequel la première source de courant comporte un premier convertisseur numérique-analogique commandé par un premier code numérique de commande ;
- un circuit d'initialisation de l'élément capacitif sur commande d'un signal d'initialisation ;
- un comparateur d'une première tension de charge dudit élément capacitif par rapport à une deuxième tension, ladite deuxième tension étant générée à partir d'un deuxième convertisseur numérique-analogique commandé par un deuxième code numérique de commande, le comparateur présentant une sortie de comparaison délivrant un signal de sortie présentant un retard souhaité par rapport au signal d'initialisation ; et

dans lequel, lors d'une phase d'utilisation du circuit de génération de retards, seul un code, dit code de sélection, parmi les premier et deuxième codes numériques de commande est utilisé pour sélectionner le retard souhaité, l'autre code de commande, dit code de réglage, restant à une valeur prédéfinie ; et

dans lequel, lors d'une phase de calibration du circuit de génération de retards, les premier et deuxième codes numériques de commande, ainsi que le signal d'initialisation, sont commandés par un dispositif de calibration, et le signal de sortie est reçu par le dispositif de calibration, afin de définir ladite valeur prédéfinie du code de réglage en mettant en oeuvre un procédé de calibration.

Selon un mode de réalisation, le circuit comprend un circuit de calibration de retards relié au circuit de génération d'un retard, le circuit de calibration comprenant un comparateur de phase recevant sur une entrée ledit signal de sortie du circuit de génération d'un retard et sur une autre entrée un signal de calibration, le circuit de calibration mettant en oeuvre, dans une phase de calibration préalable à la phase d'utilisation, le procédé de calibration.

Selon un mode de réalisation, le deuxième délai de référence correspond à une période d'un signal d'horloge de référence, dans lequel le signal d'horloge est généré par un dispositif de génération d'horloge du circuit.

Selon un mode de réalisation, le circuit comprend plusieurs circuits identiques de génération d'un retard, un deuxième circuit de génération d'un retard étant utilisé pour mettre en oeuvre le procédé de calibration sur un premier circuit de génération d'un retard, en mettant en oeuvre le procédé de calibration utilisant un deuxième circuit de génération de retards identique audit circuit de génération de retards, dans lequel, lors des étapes b1) ou b2), le deuxième circuit de génération de retards est utilisé pour générer ledit signal de calibration en entrée du comparateur, le signal d'initialisation du deuxième circuit de génération de retards étant respectivement synchrone avec le signal d'initialisation du premier circuit de génération de retards ou différé d'un délai égal au deuxième délai de référence.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une représentation très schématique d'un exemple de retardateur à rampe du type auquel s'appliquent des modes de réalisation qui vont être décrits ;

la figure 2 représente, par des vues Fig 2A, Fig 2B et Fig 2C (figures 2A, 2B, 2C), des chronogrammes illustrant le fonctionnement d'un retardateur à rampe du type de celui décrit en relation avec la figure 1 ;

la figure 3 représente, de façon très schématique et sous forme de blocs, un mode de réalisation d'un générateur de retards ;

la figure 4 représente de façon schématique un mode de réalisation d'un convertisseur numérique-analogique ;

la figure 5 illustre, par des vues Fig 5A et Fig 5B (figures 5A, 5B), de façon très schématique et sous forme de chronogrammes, certains paramètres conditionnant le fonctionnement d'un générateur de retards ;

la figure 6 représente, de façon très schématique et sous forme de blocs, un exemple d'architecture de circuit électronique comportant plusieurs voies comportant chacune un circuit retardateur programmable ; et

la figure 7 illustre, par des vues Fig 7A et Fig 7B (figures 7A, 7B), respectivement une première et une deuxième phase d'un exemple de procédé de recherche d'un code et de valeurs représentées en figure 5B.

Description des modes de réalisation

De mêmes éléments ont été désignés par de mêmes références aux différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la destination des retards générés n'a pas été détaillée, les modes de réalisation étant compatibles avec les destinations usuelles de signaux retardés qui dépendent de l'application, les modes de réalisation décrits étant en particulier compatibles avec les applications usuelles de retardateurs. De plus, la génération des signaux ou évènements déclencheurs des retards générés par les circuits retardateurs des modes de réalisation décrits n'a pas été détaillée, les modes de réalisation décrits étant compatibles avec les techniques usuelles de génération des signaux déclencheurs qui dépendent de l'application.

Sauf précision contraire, lorsque l'on fait référence à deux éléments connectés entre eux, cela signifie directement connectés sans élément intermédiaire autre que des conducteurs, et lorsque l'on fait référence à deux éléments reliés ou couplés entre eux, cela signifie que ces deux éléments peuvent être directement reliés (connectés) ou être reliés par l'intermédiaire d'un ou plusieurs autres éléments.

Dans la description qui suit, lorsqu'on fait référence aux termes "approximativement", "environ" et "de l'ordre de", cela signifie à 10 % près, de préférence à 5 % près.

En outre, le terme étalonnage ou calibration sera utilisé dans la présente description, les deux termes ayant une signification identique.

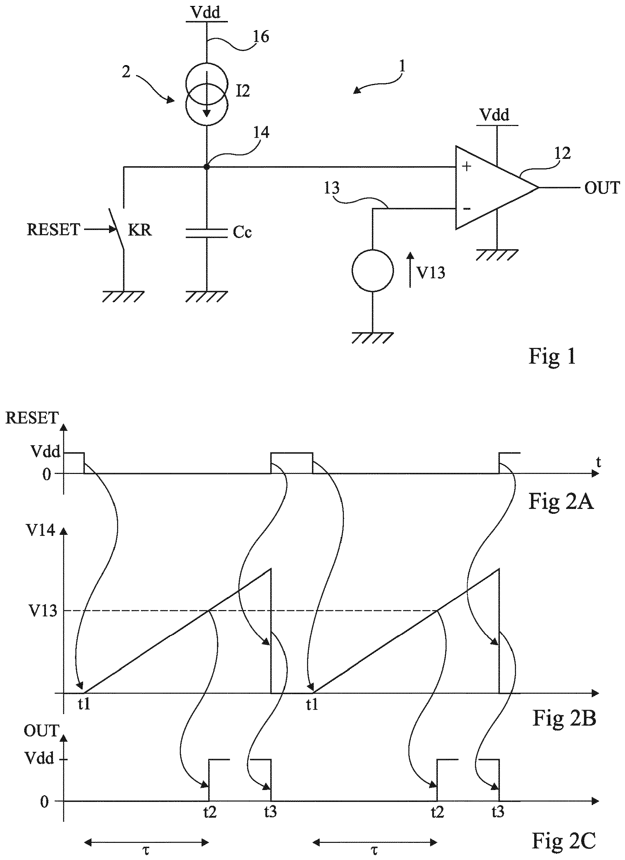

La figure 1 est une représentation très schématique d'un exemple de retardateur à rampe du type auquel s'appliquent des modes de réalisation qui vont être décrits.

Le circuit comporte un comparateur 12 dont une entrée 13 (par exemple inverseuse (-)) reçoit une tension de référence ou de consigne V13 et dont l'autre entrée 14 (par exemple non-inverseuse (+)) est reliée, de préférence connectée, à une première électrode d'un condensateur Cc dont l'autre électrode est reliée, de préférence connectée, à la masse. Le condensateur Cc est destiné à être chargé par une source 2 de courant I2 constant alimentée par une tension continue Vdd. La source de courant 2 relie une borne 16 d'application de la tension Vdd au noeud 14. Par ailleurs, le noeud 14 est relié à la masse par un commutateur KR de réinitialisation. Le commutateur KR est en parallèle avec le condensateur Cc et permet de le décharger à chaque fermeture de l'interrupteur KR. En d'autres termes, une ouverture de l'interrupteur KR constitue le déclencheur de la temporisation ou l'initialisation du retard. Après chaque ouverture de l'interrupteur KR, le potentiel du noeud 14 croit sous l'effet de la charge du condensateur Cc par le courant I2 fourni par la source 2. Dès que le potentiel atteint le seuil correspondant à la tension V13, la sortie OUT bascule.

Les figures 2A, 2B et 2C sont des chronogrammes illustrant le fonctionnement d'un retardateur à rampe du type de celui décrit en relation avec la figure 1.

La figure 2A illustre un exemple d'allure du signal RESET de commande de l'interrupteur KR. La figure 2B illustre un exemple correspondant d'évolution de la tension V14 aux bornes du condensateur Cc. La figure 2C illustre l'allure correspondante du signal OUT. Les signaux RESET et OUT sont des signaux en tout ou rien (0 ou 1) tandis que le signal V14 est une rampe de tension.

A chaque instant t1 où l'interrupteur KR est ouvert (figure 2A), un cycle de charge du condensateur Cc par le biais de la source de courant 2 commence. La tension V14 (figure 2B) commence à croitre et, quand (instant t2) cette tension V14 atteint le seuil V13, la sortie OUT (figure 2C) du comparateur 12 bascule (dans cet exemple, vers l'état haut) . La tension V14 continue à croître après l'instant t2, le cas échéant jusqu'à saturation, tant que la décharge du condensateur Cc n'est pas provoquée par la fermeture de l'interrupteur KR. Dès l'instant (t3) où le signal RESET repasse (arbitrairement) à l'état haut pour fermer l'interrupteur KR, le condensateur Cc est déchargé, et l'on peut recommencer un nouveau cycle.

Les niveaux haut et bas du signal OUT sont liés à la tension d'alimentation du comparateur 12 et sont arbitrairement notés comme étant Vdd et zéro (la masse) en négligeant notamment les chutes de tension dans les transistors à l'état passant du comparateur 12. De même, on suppose arbitrairement un signal RESET dont les états haut et bas sont respectivement Vdd et la masse.

Le retard $\tau$ (écart entre les instants t1 et t2) peut être programmé en contrôlant la pente de la rampe, c'est-à-dire le courant de charge ou la capacité du condensateur Cc, la tension de référence V13 du comparateur 12, ou la charge initiale du condensateur Cc.

Une solution analogique de génération de rampe telle qu'illustrée par la figure 1 est souvent préférée aux solutions purement numériques des deux autres catégories (à compteur ou à éléments retardateurs logiques) pour sa linéarité. En effet, à condition que la charge du condensateur Cc s'effectue bien sous courant constant, la rampe analogique présentée en entrée non-inverseuse 14 du comparateur 12 est bien linéaire.

Toutefois, la consigne de la valeur du retard souhaitée est souvent numérique et le courant I2 de charge du condensateur Cc, ou la tension de référence V13, est alors fourni par un convertisseur numérique-analogique.

Pour disposer d'un générateur fiable, la relation entre le code numérique fourni au convertisseur numérique-analogique et la valeur du retard obtenu doit être également fiable. Or, de nombreux paramètres tels que, entre autres, les dispersions technologiques entre les composants, les différences de tension d'alimentation, etc., peuvent influer sur cette relation code-retard. En particulier, pour pouvoir utiliser de façon fiable un générateur de retards, on souhaite pouvoir calibrer le générateur, notamment en termes de plage de codes fournissant une variation linéaire du retard.

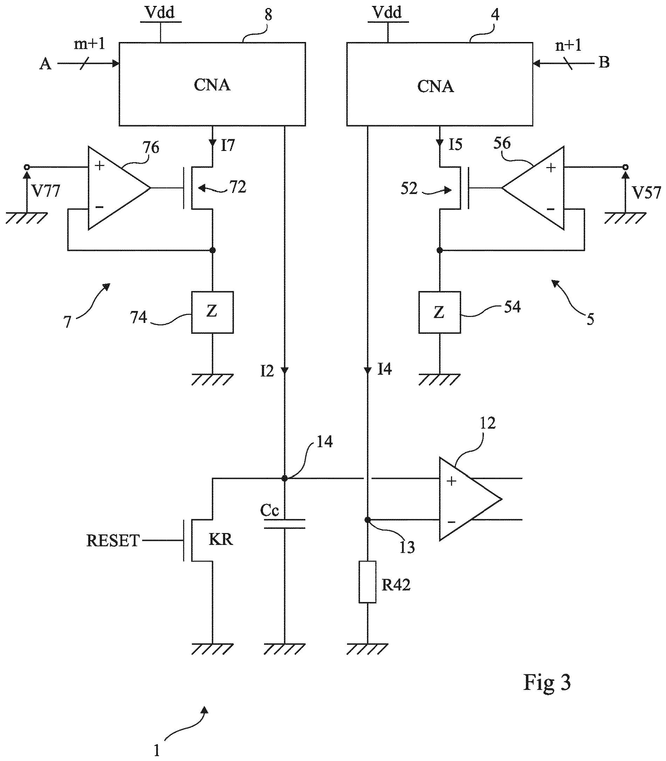

La figure 3 représente, de façon très schématique et sous forme de blocs, un mode de réalisation d'un générateur de retards.

Selon ce mode de réalisation, à la fois le courant I2 de charge du condensateur Cc de génération de la rampe et la tension V13 fixant l'instant de basculement de la sortie du comparateur 12, donc le retard, sont générés par des convertisseurs numérique-analogique (CNA).

Ainsi, le noeud 14 est relié, de préférence connecté, en sortie analogique d'un convertisseur numérique-analogique 8. Le convertisseur 8 convertit un mot binaire A de m+1 (par exemple compris entre huit et seize) bits A0, ..., Am en un courant I2. Le convertisseur 8 est alimenté par la tension Vdd et utilise un courant de référence I7 pour générer le courant I2. La valeur du courant I2 est fonction de la consigne numérique A et du courant I7.

Côté référence du comparateur 12 (ici à sorties différentielles), le noeud 13, correspondant à l'entrée inverseuse (-) du comparateur 12, est relié, de préférence connecté, à une première borne d'une résistance R42 dont l'autre borne est reliée, de préférence connectée, à la masse. Un convertisseur numérique-analogique 4 convertit un mot binaire B de n+1 (par exemple compris entre huit et seize) bits B0, ..., Bn en un courant I4. La sortie du convertisseur 4, fournissant le courant I4, est reliée, de préférence connectée, au noeud 13. Le convertisseur 4 est alimenté par la tension Vdd et utilise un courant de référence I5 pour générer le courant I4.

Les courants de référence I5 et I7 sont, par exemple, générés à partir de sources de courant 5 et 7 basées sur une conversion de tensions de référence constantes, respectivement V57 et V77. Dans l'exemple représenté en figure 3, chaque source de courant 5, respectivement 7, est basée sur un transistor MOS 52, respectivement 72, en série avec une impédance résistive 54, respectivement 74. Les impédances résistives 54 (valeur R54) et 74 (valeur R74) sont, par exemple, des résistances ou des circuits définissant des résistances (par exemple, des circuits à capacités commutées). Chaque transistor 52, 72 est commandé par un montage suiveur comportant un amplificateur opérationnel 56, respectivement 76, dont une entrée non inverseuse (+) reçoit la tension constante de référence V57, respectivement V77, et dont une entrée inverseuse (-) est connectée entre le transistor 52, respectivement 72, et la résistance 54, respectivement 74.

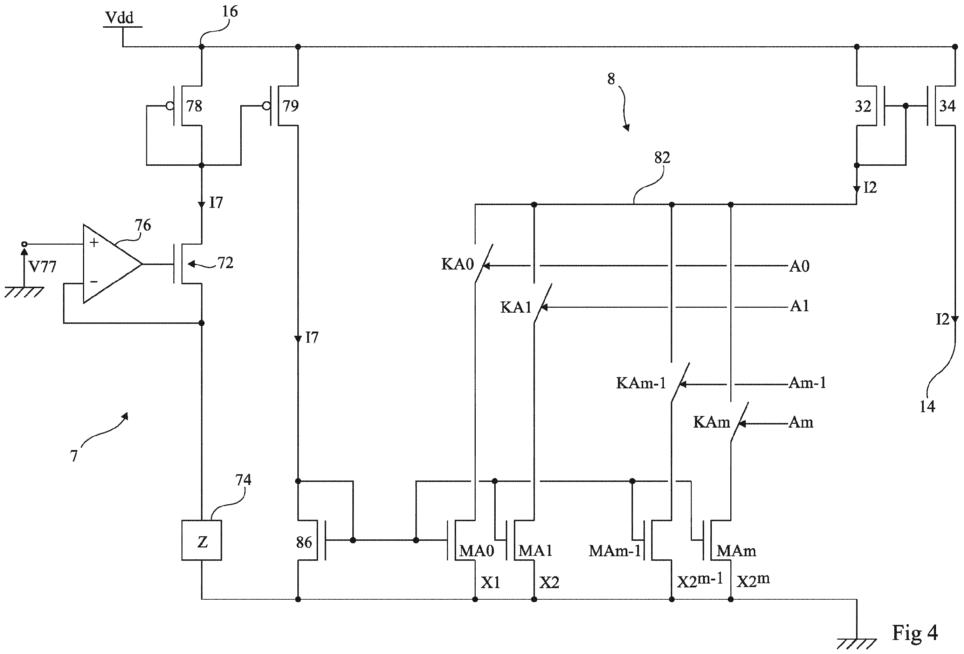

La figure 4 représente de façon schématique un mode de réalisation d'un convertisseur numérique-analogique 8 et de relation entre la source de courant 7 et le courant I2.

On prend arbitrairement pour exemple la réalisation du convertisseur 8 et de la source de courant 7, mais la description qui suit de la figure 4 se transpose à une description du convertisseur 4 et de la source de courant 5 avec une simple transposition des références numériques.

Le courant I2 correspond à la somme des courants dans les m+1 branches en parallèle du convertisseur 8 qui sont individuellement commandées par l'un des bits Aj (j compris entre 0 et m) du mot A. Chaque branche comporte, entre un noeud 82 et la masse, un commutateur KA0, KA1, ..., KAm-1, KAm, et un transistor MOS MA0, MA1, ..., MAm-1, MAm. On préfère généralement générer le courant I2 du convertisseur 8 par rapport à une référence à la masse et effectuer ensuite une recopie de ce courant pour l'injecter dans le condensateur Cc. Ainsi, un transistor 32 (par exemple MOS) relie le noeud 82 à la borne 16 d'application de la tension Vdd. La grille et le drain du transistor 32 sont interconnectés. Un transistor 34, de même type que le transistor 32, est monté en miroir sur le transistor 32 avec sa source reliée, de préférence connectée, à la borne 16. La grille du transistor 34 est connectée à la grille du transistor 32 et son drain est relié, de préférence connecté, au noeud 14. Avec des transistors 32 et 34 ayant des rapports de surface identiques, le courant circulant dans le transistor 34 est égal au courant I2 circulant dans le transistor 32.

Côté courant I7, les transistors MAj sont montés en miroir de courant sur un transistor 86 dans lequel circule le courant I7 fourni par la source 7 de courant constant. Ainsi, le drain et la grille du transistor 86 sont interconnectés et sa source est reliée, de préférence connectée, à la masse. Les grilles des transistors MAj sont connectées à la grille du transistor 86. Par ailleurs, les rapports de surface des transistors MAj doublent avec le rang j. En d'autres termes, en supposant un transistor MA0 de rapport de surface normalisé 1 (2°), le transistor MA1 a un rapport de surface 2 (i.e. $2^1$), un transistor MAj a un rapport de surface $2^j$, le transistor MAm-1 a un rapport de surface $2^{m-1}$ et le transistor MAm a un rapport de surface $2^m$. Ainsi, le courant I2 peut s'écrire :

$$I2 \; = I7 \times \sum_{j=0}^{m}(Aj \times 2^j)$$

Dans l'exemple de la figure 4, où l'on suppose que la source de courant 7 est celle représentée en figure 3, le courant I7 est fourni au transistor 86, là aussi, par un montage en miroir de courant. Ainsi, par exemple, un transistor 78 (par exemple PMOS) est placé entre le transistor 72 (son drain) et la borne 16 d'application de la tension Vdd. Un transistor 79, de même type que le transistor 78, est monté en miroir de courant sur le transistor 78 avec sa source reliée, de préférence connectée, à la borne 16, sa grille connectée à la grille du transistor 78 et son drain relié, de préférence connecté, au drain du transistor 86. Avec des transistors 78 et 79 ayant des rapports de surface identiques, le courant circulant dans le transistor 79, donc dans le transistor 86, est égal au courant I7 circulant dans le transistor 72.

On prévoit de tirer profit d'une architecture de circuit retardateur à convertisseurs numériques-analogiques du type de celui décrit en relation avec les figures précédentes pour calibrer ou étalonner une ou plusieurs voies de génération de retards programmables dans un circuit électronique.

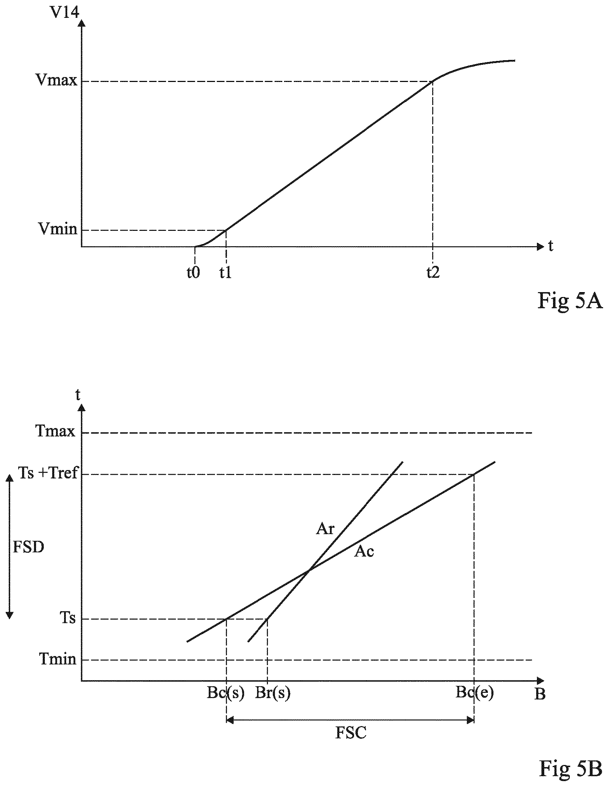

La figure 5A représente une occurrence d'une rampe de tension au noeud 14. L'allure de la figure 5A illustre le fait que la rampe de tension V14 n'est pas linéaire sur toute sa plage, mais souffre d'un défaut de linéarité au début et/ou à la fin. Par exemple, entre un instant t0 où l'interrupteur KR est ouvert et un instant t1, l'évolution de la tension V14 n'est pas linéaire. Par ailleurs, si la tension de référence V13 est choisie trop haute, on assiste à un phénomène de saturation (à partir d'un instant t2) et on perd l'allure linéaire de la pente. Ainsi, la plage de la tension V14 dans laquelle la variation est linéaire et permet une commande correcte par un mot numérique B est entre les instants t1 et t2.

On peut définir, pour un générateur de retards à commande numérique, des valeurs « extrêmes » minimale Vmin et maximale Vmax de la tension V14 définissant cette plage de variation linéaire. Ensuite, on va rechercher entre ces valeurs extrêmes des valeurs limite basse V(B(s)) et limite haute V(B(e)) qui correspondent à des mots numériques B(s) et B(e) de commande et des retards minimum T(s) et maximum T(e) tels que le nombre de mots numériques de commande égal à B(e)-B(s) correspond à une plage prédéfinie de retards appelée pleine échelle FSV (pour « Full Swing Voltage » en anglais). On notera que la courbe représentée en figure 5B correspond à une valeur de commande A. En pratique, la plage de retards FSV est choisie telle qu'elle correspond à une variation linéaire quelle que soit la valeur de commande A.

Une difficulté réside dans le fait que le fonctionnement d'un circuit retardateur et sa plage de linéarité peuvent varier, entre autres, sous l'effet de dispersions technologiques de fabrication. Par ailleurs, on peut également assister à certaines dérives dans le fonctionnement liées au vieillissement ou à d'autres facteurs.

Le fait de prévoir de générer les courants I2 et I4 au moyen de convertisseurs numérique-analogique apporte une capacité d'étalonnage du circuit de génération de retards. Une fois le circuit étalonné, ou calibré, seule la commande B est utilisée pour commander la valeur de retard souhaitée, tandis que la commande A est fixe.

Ainsi, la valeur T du retard est fixée par la valeur de la tension V13 qui est déterminée par le mot numérique B. En effet, cette tension V13 vaut :

$$V13 = R42 \times I4$$

Et le courant I4 peut s'exprimer :

$$I4 = I5 \times \sum_{i=0}^{n}(Bi \times 2^i)$$

Par conséquent, la tension V13 peut s'écrire :

$$V13 = \frac{R42 \times V57}{R54} \times \sum_{i=0}^{n}(Bi \times 2^i)$$

Au moment où le comparateur 12 bascule (retard T), la tension V14 peut s'exprimer sous la forme :

$$V14 = \frac{I2}{Cc} \times T$$

Or, le courant I2 peut s'écrire :

$$I2 = \frac{V77}{R74} \times \sum_{j=0}^{m}(Aj \times 2^j)$$

Par conséquent, le retard T peut s'exprimer :

$$T = \frac{R42 \times V57}{R54} \times \frac{Cc \times R74}{V77} \times \frac{\sum_{i=0}^{n}(Bi \times 2^i)}{\sum_{j=0}^{m}(Aj \times 2^j)}$$

En supposant que les tensions V77 et V57 sont identiques (et correspondent à une tension de référence de préférence identique), le retard T peut s'exprimer :

$$T = \frac{R42}{R54} \times Cc \times R74 \times \frac{\sum_{i=0}^{n}(Bi \times 2^i)}{\sum_{j=0}^{m}(Aj \times 2^j)}$$

On voit donc qu'avec un circuit du type de celui représenté en figure 3, il est possible de compenser d'éventuelles dispersions technologiques de fabrication, notamment influant sur les valeurs des composants R54, R74, R42 et Cc, en réglant la valeur du mot A pour que le circuit retardateur fournisse une valeur de retard fiable en fonction de la valeur du mot B.

Selon un mode de réalisation simplifié, on prévoit, dans une phase d'étalonnage, par exemple lors des tests en fin de fabrication du circuit électronique intégrant le retardateur programmable, de déterminer de façon empirique le code A à fixer afin d'obtenir la dynamique (plage de retards fiable possible) souhaitée.

De préférence, on effectue cependant cet étalonnage à partir d'un retardateur de référence.

Dans un mode de réalisation, on tire profit du fait qu'un circuit électronique intégrant des retardateurs programmables ne comporte généralement pas qu'un seul retardateur mais le plus souvent plusieurs (au moins deux) voies de génération de retards, toutes basées sur des structures identiques. Il est alors possible, dans une phase de calibration ou d'étalonnage, de calibrer une ou plusieurs voies en référence à une autre voie.

Selon un mode de réalisation, on définit une voie de référence une fois pour toute, par exemple, une voie qui a été étalonnée empiriquement et on utilise cette voie de référence pour calibrer les autres voies de retards.

Toutefois, comme on le verra par la suite, on peut également, dans un mode de réalisation préféré, utiliser une première voie quelconque, même non calibrée, comme voie de référence pour étalonner une ou plusieurs voies, cette première voie étant ensuite par exemple elle-même étalonnée, à l'aide de l'une quelconque des autres voies.

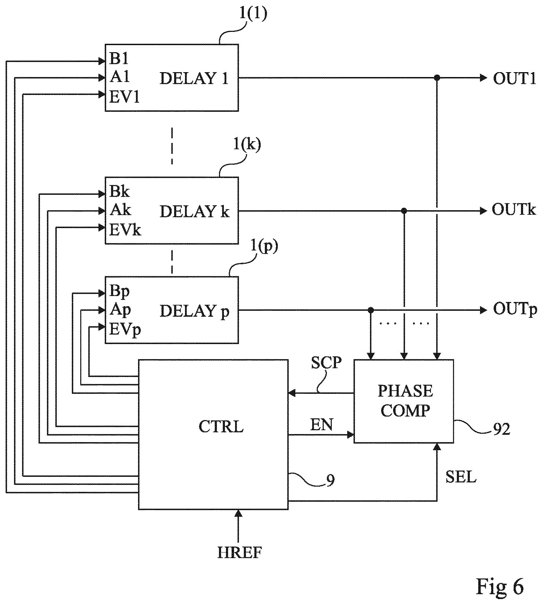

La figure 6 représente, de façon très schématique et sous forme de blocs, un exemple d'architecture de circuit électronique comportant plusieurs (p) voies k (k compris entre 1 et p) comportant chacune un circuit retardateur programmable 1(k) (DELAY k) tel que décrit ci-dessus.

Le nombre p de voies k dépend de l'application et du nombre de retards différents à générer dans le circuit électronique.

Chaque voie k comporte un circuit programmable 1(k) tel qu'illustré par la figure 3. Chaque circuit 1(k) fournit, sur une borne OUTk le retard attendu, c'est-à-dire une impulsion retardée d'une durée Tk par rapport à l'apparition d'un signal déclencheur (noté ici EVk). En pratique, le signal EVk peut être relié au signal de reset RESET du générateur précédemment décrit.

Le retard Tk(B) généré par une voie k pour une valeur donnée de Bk peut s'écrire :

$$Tk(Bk) = Tk(0) + Bk.Pk(Ak)$$

où :

Tk(0) est le retard minimum ou intrinsèque de la voie pour Bk=0 ; et
Pk(Ak) représente le coefficient de la pente du retard, qui, ici, est programmable par la valeur Ak.

Comme ce retard dépend en fait de la valeur Ak, on notera par la suite le retard Tk apporté par la voie k avec les deux arguments ou codes Bk et Ak, soit Tk(Bk, Ak).

Pour décrire le fonctionnement du processus d'étalonnage, on suppose arbitrairement, dans l'exemple de la figure 6, que l'on calibre une voie identifiée « c » (k = c) à partir d'une voie de référence identifiée « r » (k = r). Comme indiqué précédemment, le choix de la voie de référence pour l'étalonnage d'une voie donnée du circuit de la figure 6 n'a pas d'importance.

Pour chaque étalonnage, on peut définir les valeurs suivantes :

Bc(e) : la valeur finale ou maximale du code B de la voie à calibrer ;
Bc(s) : la valeur initiale ou minimale du code B de la voie à calibrer ;
Br(s) : la valeur initiale ou minimale du code B de la voie de référence ;
Ts : une valeur de délai minimale de référence ;
Tref : une valeur de délai de référence correspondant à la pleine échelle de délais souhaitée FSD ;
Ar : la valeur du code A définissant le gain de conversion de la pente de la voie de référence.

Pour calibrer la voie c, on cherche à déterminer le code Ac (représentant le gain de la rampe de charge de l'élément capacitif Cc) et la valeur initiale Bc(s) permettant de fournir une pleine échelle de délais (FSD), c'est-à-dire une variation linéaire du retard Tc de la voie c sur toute la plage de codes Bc(s) à Bc(e) et tel que l'amplitude de la plage de délais entre ces codes, correspondant à la pleine échelle de délais FSD, soit égale à un délai de référence prédéfini Tref.

Autrement dit, en fin de calibration, les codes Bc(s) et Ac recherchés vérifient, sensiblement, l'équation 0 suivante :

$$Pc(Ac).(Bc(e) - Bc(s)) = Tref \quad (équation \ 0)$$

Selon un mode de réalisation simplifié, on détermine la valeur Ac de façon empirique ou par un processus itératif faisant appel à une voie de référence.

Dans une phase préliminaire, on fixe arbitrairement, côté voie de référence, une valeur de code Ar ainsi qu'une valeur de code initiale Br(s) correspondant à un délai Tr(s) égal au délai minimal de référence Ts. On choisit également une valeur de pleine échelle de codes FSC, c'est-à-dire une dynamique de variation du code B entre les futures valeurs identifiées Bc(s) et Bc(e), telle que FSC = Bc(e) - Bc(s).

La valeur de délai minimal Ts, correspondant à la valeur de code initiale Br(s), est choisie plutôt petite, mais néanmoins supérieure à la valeur extrême minimale susmentionnée encadrant la zone de linéarité.

La figure 5B illustre les délais obtenus pour différentes valeurs de codes B, en fonction des valeurs de codes A des voies à calibrer et de référence. La courbe de la voie à calibrer représentée correspond à la valeur de code Ac que l'on recherche et qui remplit les critères susmentionnés.

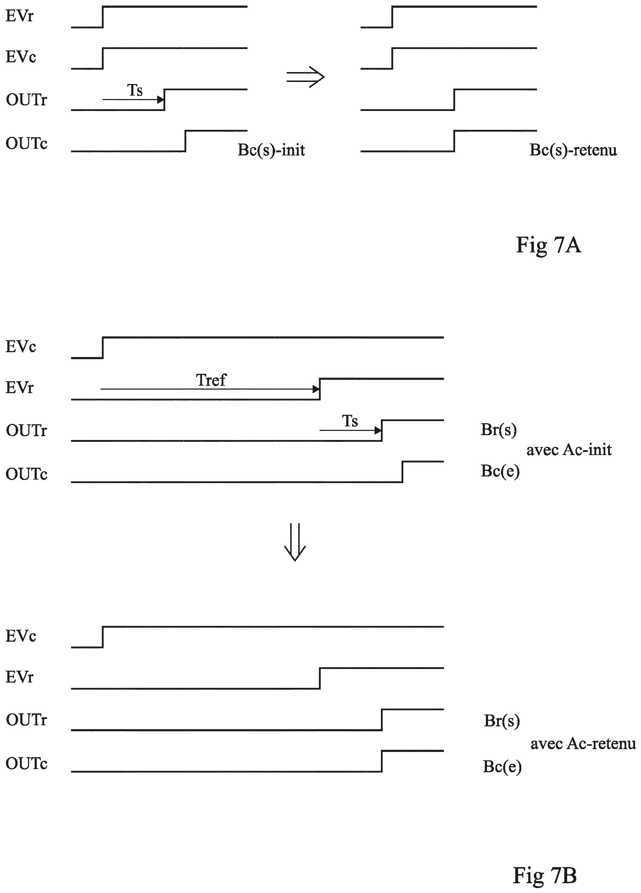

Les figures 7A et 7B illustrent respectivement une première et une deuxième phase d'un exemple de procédé de recherche du code Ac et des valeurs Bc(s) et Bc(e) telles que définies ci-dessus et représentées en figure 5B.

Dans une première phase, on initialise le code Ac à une valeur initiale (Ac-init), par exemple choisie aléatoirement, et on recherche le code Bc(s) qui remplit la condition (équation 1) suivante :

$$Tc(Bc(s),Ac) = Tr(Br(s),Ar) = Ts \quad (équation\ 1)$$

ou encore :

$$Tc(0) + Bc(s).Pc(Ac) = Tr(0) + Br(s).Pr(Ar)$$

Pour trouver le code Bc(s) qui remplit cette condition, on peut procéder par essais successifs sur les codes B. Ainsi, la figure 7A représente à gauche un premier essai avec un premier code Bc(s)-init. Pour ce premier essai, on voit que les délais des voies c (à calibrer) et r (de référence) sont différents et que l'équation 1 n'est pas respectée. Un énième essai de code Bc(s) est représenté sur la droite de la figure 7A, et il permet d'établir le code Bc(s)-retenu pour cette première phase permettant de vérifier l'équation 1 car on voit que les délais sur les deux voies c et r sont identiques et égaux à Ts.

Dans une deuxième phase, on définit le code final Bc(e) de la voie à calibrer c comme valant :

$$Bc(e) = Bc(s) + FSC$$

On applique le code Bc(e) sur la voie c et on fait varier la valeur du code Ac jusqu'à obtenir un retard Tc égal au retard Ts, majoré du délai de référence Tref (Tc=Ts+Tref). Ce délai Tref correspond par exemple à une période d'une horloge de référence HREF.

On obtient alors l'équation 2 suivante :

$$Tc(0) + Bc(e).Pc(Ac) = Ts + Tref \quad (équation\ 2)$$

Pour trouver ce code Ac qui remplit cette condition, on peut procéder par essais successifs sur les codes Ac en pilotant les voies c et r différemment (contrairement à la première phase). On applique sur la voie de référence r, un code Br(s) (permettant de générer le délai minimum de référence Ts), un code Ar inchangé, et un signal déclencheur EVr retardé par rapport au signal EVc, avec un retard égal au délai de référence Tref. On génère ainsi en sortie de la voie r un signal équivalent à un délai, de durée Ts+Tref, entre l'activation du signal EVc et le front de changement d'état de la sortie du signal OUTr.

Sur la voie à calibrer, on applique le code Bc(e) (= Bc(s) + FSC) et on applique un code Ac correspondant initialement au code Ac-init utilisé dans la première phase. On compare ensuite les instants d'apparition des fronts sur les signaux de sortie des voies c et r pour savoir si le code Ac actuel permet d'obtenir le délai Tc souhaité. L'ordre d'apparition des fronts permet de savoir s'il faut augmenter ou diminuer Ac pour converger vers le code Ac donnant le délai souhaité (égal à Ts+Tref).

Ainsi, la figure 7B représente en haut un premier essai avec le premier code Ac-init. Pour ce premier essai, on voit que les délais des voies c (à calibrer) et r (de référence) sont différents et que l'équation 2 n'est pas respectée. Un énième essai de code Ac est représenté en dessous, et il permet d'établir le code Ac-retenu pour cette deuxième phase permettant de vérifier l'équation 2 car on voit que les délais sur les deux voies c et r sont identiques et égaux à Ts+Tref.

On notera que les courbes, plus précisément les approximations linéaires de ces courbes de délais en fonction des codes B, diffèrent en pente et en ordonnée à l'origine, en fonction du code A appliqué au générateur de délais. Ainsi, si les courbes sont assez dispersées, le délai sur la voie à calibrer obtenu avec le code Bc(s) défini en première phase risque de différer du délai minimal de référence Ts. Dans ce cas, l'équation 0 susmentionnée correspondant à l'objectif final de calibration n'est donc peut-être pas tout de suite vérifiée. Ainsi, pour arriver à trouver le code Bc(s) et le code Ac permettant de vérifier au mieux l'équation 0, on répète manuellement ou automatiquement la première phase et la deuxième phase ci-dessus jusqu'à ce que l'équation ci-dessous soit respectée au mieux en ajustant Bc(s) pour chaque nouvelle valeur Ac que l'on essaie. On obtient alors :

$$Tref = Pc(Ac).FSC$$

Selon un mode de réalisation, on tire profit de l'architecture du circuit électronique à plusieurs voies de retards programmables tel qu'illustrée par la figure 6 pour effectuer un étalonnage ou une calibration automatique.

Selon ce mode de réalisation, le circuit de la figure 6 comporte en outre une unité 9 de commande d'étalonnage (CTRL) fournissant, aux différentes voies du circuit 1 :

le code B ;

le code A ; et

un signal de commande EV. Ce signal EV correspond en fait à une impulsion de fin de remise à zéro, c'est-à-dire du signal RESET pour déclencher un nouveau retard, soit un front descendant permettant le redémarrage de la génération du retard.

L'unité de commande 9 reçoit une horloge de référence HREF, c'est-à-dire un signal périodique de période Tref.

De plus, l'unité de commande 9 reçoit, à chaque mesure, une information SCP représentative, entre deux fronts des signaux de sortie correspondant à des retards, de celui des fronts qui est en avance (ou en retard) par rapport à l'autre. Cette information est fournie par un comparateur de phase 92 (PHASE COMP) qui, suite à chaque déclenchement par un signal d'activation EN, détermine la sortie OUT qui bascule en premier. En pratique et comme on le verra par la suite, comme la calibration s'effectue d'une voie par rapport à une autre, le comparateur de phase 92 n'exploite que deux de ses entrées à chaque fois. Ces deux voies sélectionnées sont indiquées par l'unité de commande 9 au comparateur de phase 92 par un signal de sélection SEL. Dans la suite de la description on prend la convention suivante, si la première voie sélectionnée déclenche un front avant la seconde voie sélectionnée, le signal SCP prend la valeur 1, et inversement.

L'étalonnage s'effectue de façon itérative pour différentes valeurs Ac, jusqu'à converger vers des valeurs initiales Bc(s) et de pleine échelle FSD et FSC souhaitées.

Cette détermination itérative s'effectue, par exemple, en utilisant une valeur binaire NMES stockée dans un registre NMES du circuit 9 et conditionnant la périodicité des remises à zéro, c'est-à-dire des impulsions des signaux EVc (k=c) et EVr (k=r).A partir du signal d'horloge HREF de période Tref, on génère un signal HMES de période Tref*(2^NMES) synchrone du front montant de HREF, où NMES représente le facteur de division du signal d'horloge de référence HREF. La périodicité des mesures, réglée avec NMES, est adaptée au temps nécessaire au circuit 9 pour réaliser l'ensemble des opérations qu'il doit exécuter. Comme on le comprendra par la suite, la mesure doit à minima durer 2 périodes Tref, lorsqu'on évalue le code Ac, et en pratique le nombre de périodes Tref pour une mesure sera sans doute plus élevée pour pouvoir réaliser les calculs, et le nombre NMES sera d'autant plus élevé que la période Tref est petite - ce qui sera le cas si on veut faire un générateur de délais très courts, pour lequel la présente invention est particulièrement bien adaptée.

Dans une première phase (phase 1), on applique les conditions suivantes aux entrées des voies c et r pour générer des délais sur les sorties OUTc et OUTr respectives :

Ac

Ar

Bc = Bc(s)

Br = Br(s)= Ts

EVc = EVr = HMES

Par ailleurs, le comparateur de phase 92 sélectionne, par le signal SEL adéquat fourni par l'unité de commande 9, les signaux de ces voies pour effectuer la comparaison.

La même mesure (codes A et B inchangés) est répétée plusieurs fois pour fiabiliser le résultat de la mesure (notion de redondance). Pour ce faire, on utilise un registre RMES.

On initialise le registre RMES à '0'.

A chaque front montant du signal HMES, on déclenche une acquisition du comparateur de phase 92 en activant le signal EN. Si le résultat en sortie SCP du comparateur de phase est 1, on incrémente la valeur contenue dans le registre RMES de 1. Sinon, on laisse la valeur inchangée. Ces trois étapes (génération de délais, comparaison, incrémentation ou non du registre) sont répétées 2^NRM fois, où NRM représente le nombre de répétitions de mesures.

A l'issue de ces itérations, le contenu du registre RMES est analysé de la façon suivante : si le code BC(s) est tel que les délais sur les deux voies sont égaux à Ts alors on obtient une fois sur deux en moyenne la valeur 1 sur le signal SCP (le contenu du registre RMES prend alors une valeur médiane de l'ordre de 2^(NRM-1)). Si le délai associé à Bc est éloigné du délai Ts, on obtient beaucoup ou très peu de valeurs égales à 1 dans les comparaisons successives ou inversement, et le contenu du registre RMES s'éloigne de la valeur médiane.

L'analyse de RMES permet de modifier le code Bc de la voie c pour une nouvelle salve de mesures. On procède ainsi, par itérations successives, jusqu'à obtenir une valeur Bc(s)-retenu telle que le contenu du registre RMES soit de l'ordre de 2^(NRM-1).

Dans une deuxième phase (phase 2), dite de pleine échelle, à partir du signal HREF, on génère toujours un signal HMES de période Tref*(2^NMES) synchrone du front montant du signal HREF. A partir de HMES, on génère aussi un signal HMESD, retardé d'une période du signal HREF par rapport à HMES. Puis, on applique les conditions suivantes aux entrées des voies c et r pour générer des délais sur les sorties OUTc et OUTr respectives :

Ac
Ar
Bc = Bc(s)-retenu
Br = Br(s)
EVc = HMES
EVr = HMESD

Le comparateur de phase 92 sélectionne toujours les signaux de ces mêmes voies pour effectuer la comparaison.

La même mesure (codes A et B inchangés) est répétée plusieurs fois pour fiabiliser le résultat de la mesure (notion de redondance). Pour ce faire, on utilise comme précédemment le registre RMES.

On initialise le registre RMES à 0. On applique la valeur Bc(s)-retenu dans le registre Bc de la voie c. Puis, on calcule Bc(e) = Bc(s)-retenu + FSC.

A chaque front montant du signal HMES, on déclenche une acquisition du comparateur de phase 92 en activant le signal EN. Comme précédemment, si le résultat en sortie SCP du comparateur de phase est 1, on incrémente la valeur contenue dans le registre RMES de 1. Sinon on laisse la valeur inchangée. On répète 2^NRM fois cette opération.

Le contenu du registre RMES est ensuite analysé selon la procédure suivante : si le code Ac est tel que les délais sur les 2 voies sont égaux à Ts+Tref, alors on obtient une fois sur deux en moyenne la valeur 1 sur le signal SCP (le contenu du registre RMES prend une valeur médiane de l'ordre de 2^(NRM-1)). Si le délai associé à Ac est éloigné du délai Ts+Tref, on obtient beaucoup ou très peu de valeurs égales à 1 dans les comparaisons successives ou inversement, et le contenu du registre RMES s'éloigne de la valeur médiane.

L'analyse de RMES permet de modifier le code Ac pour une nouvelle salve de mesures. On procède ainsi, par itérations successives pour faire en sorte que le contenu du registre RMES soit de l'ordre de 2^(NRM-1).

L'enchaînement des phases 1 et 2 décrites ci-dessus est de préférence effectué pour chaque valeur du code Ac. Ainsi, pour chaque nouvelle valeur du code Ac essayée, on détermine un éventuel nouveau code Bc(s) en relançant une phase 1 ; puis une fois ce nouveau code Bc(s) (correspondant à un délai Ts) identifié, on relance une phase 2 pour vérifier si le nouveau code Ac permet de vérifier l'équation 0 susmentionnée.

Les phases d'étalonnage décrites ci-dessus peuvent être mises en oeuvre de façon automatique en programmant le circuit 9 pour qu'il respecte le séquencement décrit.

On notera que le séquencement des opérations décrites ci-dessous, notamment l'enchaînement des phases 1 et 2, pourrait être réalisé selon un ordre différent. On pourrait par exemple prévoir de réaliser différentes itérations de la phase 2, pour différentes valeurs de codes Ac, sans rechercher à chaque fois un code Bc(s) selon la phase 1. L'enchaînement des phases 1 et 2 permettant de converger au mieux, le plus rapidement, dépend notamment de la dispersion des approximations linéaires des courbes de délais en fonction des codes B et A appliqués au générateur de délais. Un avantage des modes de réalisation décrits est que l'on obtient un circuit électronique de génération de retards programmables particulièrement fiable, permettant d'obtenir un incrément de délai par pas de code constant (delta D / delta C = constante), correspondant à une variation linéaire sur toute la pleine échelle de codes FSC. En effet, le fait de générer dans la voie à calibrer deux délais différents (dans les exemples susmentionnés un délai « court » Tc(Bc(s), Ac) et un délai « long » Tc(Bc(e), Ac)) et d'utiliser une autre voie, ou un autre circuit, pour générer un délai court Ts et un délai long correspondant à la concaténation du délai court et d'un autre délai de référence Tref, permet en pratique de supprimer les erreurs de comparaison dues par exemple à un offset de mesure entre deux entrées du comparateur.

Un avantage des modes de réalisation susmentionnés utilisant une redondance de mesure est qu'ils permettent en pratique de calibrer des délais très courts qui sont particulièrement sensibles aux phénomènes de jitter. La redondance des mesures permet, par le moyennage, de diminuer grandement l'influence du jitter, et ceci d'autant plus que le nombre de mesures redondantes est élevé. On notera qu'un circuit de génération d'un retard selon la présente invention avec un dispositif de calibration des codes de sélection de retards est tout particulièrement adapté à la génération de délais courts, avec un pas d'incrément entre les différents délais qui soit également très court. A titre d'exemple, il est possible de générer des retards sur une plage allant de 0, ou un peu plus que 0, à environ 10 nanosecondes, avec 10 000 codes de sélection, donc avec un pas d'incrément de délai de l'ordre de 1 picoseconde.

Dans le cas où l'on souhaite générer un retard plus long que le retard maximal possible (10 ns) avec le circuit de génération de retards très précis, tout en ayant une très bonne précision de définition (égale à 1 ps), il est possible de cascader deux, ou plusieurs, circuits de génération de retards avec des plages de délais différentes.

En outre, on notera que le dispositif de calibration selon la présente invention permet de choisir, pour un circuit de génération de délais donné, la plage de codes de sélection (codes B dans les exemples susmentionnés) la plus appropriée pour permettre d'obtenir une très bonne linéarité sur la plage de codes de sélection retenue in fine. Autrement dit, l'amplitude de la plage de codes peut par exemple être égale à 2k, avec k entier (par exemple 214 = 16384), et on ne retient au final, après calibration, que n codes dans la plage de linéarité, n correspondant au nombre de pas de codes souhaité pour l'application utilisant le circuit de génération de délais (dans l'exemple susmentionné, n=10000).

Un autre avantage des modes de réalisation décrits est que la calibration des circuits de génération de retards est particulièrement simple. En particulier, peu importe les paramètres de la voie de référence, pourvu de respecter les étapes décrites, une voie à calibrer peut l'être avec une voie de référence quelconque. Ainsi, les différentes voies peuvent être calibrées par rapport à une même voie de référence ou entre-elles. Ceci est possible grâce à l'utilisation d'un délai de référence Tref, donné par exemple par une horloge de référence. Le résultat de calibration sera d'autant plus fiable que le délai de référence sera précis, notamment avec des fronts « raides » présentant très peu de déphasage d'un cycle sur l'autre (en tout cas, un déphasage inférieur à la précision recherchée, par exemple 1ps dans l'exemple susmentionné).

On notera que la calibration pourrait être réalisée autrement qu'entre deux voies, par exemple en utilisant un circuit générant un délai court Ts en phase 1 et générant un délai long Ts+Tref en phase 2, avec de préférence une concaténation de deux délais pour la génération du délai long (voir avantage de fiabilité ci-dessus). Néanmoins, dans le cas où plusieurs voies de génération de retards sont présentes dans le circuit, ce circuit supplémentaire n'est pas nécessaire et on utilise avantageusement une autre voie comme voie de référence. Dans le cas où le circuit de génération de retards comprend plusieurs voies toutes calibrées les unes par rapport aux autres selon un processus itératif, on obtiendra pour chacune des voies un délai minimal et un délai maximal identique correspondant à FSD, avec Ts correspondant en pratique au délai Tr(s) initial de la première voie choisie comme référence. Pour générer des retards sur une même plage de délais, FSD, les différentes voies pourront avoir des plages de codes de sélection retenus différentes (avec un réglage de code A et un code minimal de plage Bc(s) potentiellement différents).

Par ailleurs, dans tous les exemples décrits précédemment, le code de sélection utilisé in fine après calibration pour sélectionner le retard souhaité correspond au code B, c'est-à-dire au code qui commande la valeur de la tension de seuil V13 du comparateur 12 (figure 3). Selon d'autres modes de réalisation alternatifs, il est possible d'utiliser le code A, c'est-à-dire le code qui commande le courant de charge I2 du condensateur Cc, pour réaliser une sélection du retard souhaité. Dans ce cas, lors du procédé de calibration, il faudrait rechercher la plage de codes A permettant, après détermination de la meilleure valeur de code B pour la linéarité, d'obtenir la plage de délais souhaitée. Ainsi, dans la phase 2 de recherche, il faudrait faire varier le seuil de comparaison (comparateur 12) au lieu de faire varier la pente de charge du condensateur Cc. L'homme de l'art saura aisément adapter le procédé de calibration susmentionné à cette possibilité de sélection de retards par le code A, au lieu du code B.

Le code A, ou B, retenu après le procédé de calibration est avantageusement mémorisé dans un registre dont la sortie est reliée aux entrées de commande du convertisseur numérique associé pour appliquer, en permanence dans une phase d'utilisation du circuit de génération de délais, le même code prédéfini pendant la phase de calibration.

En outre, dans les exemples susmentionnés, l'écart entre les délais reçus par le comparateur n'est pas estimé, on recherche uniquement à vérifier si on a l'égalité des délais (valeur médiane vérifiée) ou si les délais diffèrent. Selon une variante de réalisation, on pourrait prévoir d'analyser l'amplitude de l'écart entre les délais et se servir de cette analyse pour déterminer quel futur essai de code réaliser.

Par ailleurs, dans les exemples susmentionnés, la première phase de calibration vise à trouver un code Bc(s) correspondant à la plus petite valeur de codes de la plage de codes recherchée, la plus grande valeur de codes de cette plage étant définie à partir de la pleine échelle de codes FSC ; et la deuxième phase de calibration vise à trouver un code Ac correspondant à la pente de charge du condensateur Cc. Alternativement, la deuxième phase de calibration (avec un grand délai égal à Ts+Tref) pourrait servir à identifier la plus grande valeur de codes de la plage de codes recherchée, la plus petite valeur de codes de cette plage étant alors définie à partir de la pleine échelle de codes FSC (par une soustraction au lieu d'une addition) ; et la première phase de calibration (avec un petit délai égal à Ts) pourrait servir à identifier le code Ac correspondant à la pente.

De plus, la détermination des différentes valeurs à donner aux composants du circuit de génération de retards dépend de l'application. Ces valeurs peuvent être fixées par application des formules décrites, puis affinées empiriquement ou par des tests.

Divers modes de réalisation et variantes ont été décrits. Ces divers modes de réalisation et variantes sont combinables et d'autres variantes apparaitront à l'homme de l'art. En particulier, la détermination des différentes valeurs et le dimensionnement des composants dépend de l'application et est à la portée de l'homme du métier à partir des indications fonctionnelles données ci-dessus.

**Revendications**

**1.** Procédé de calibration d'un circuit de génération d'un retard, le circuit comportant :

- un élément capacitif (Cc) d'intégration d'un premier courant (I2) fourni par une première source de courant (7), dans lequel la première source de courant comporte un premier convertisseur numérique-analogique (8) commandé par un premier code numérique de commande (A) ;
- un circuit d'initialisation de l'élément capacitif sur commande d'un signal d'initialisation (RESET) ;
- un comparateur (12) d'une première tension (V14) de charge dudit élément capacitif (Cc) par rapport à une deuxième tension (V13), ladite deuxième tension étant générée à partir d'un deuxième convertisseur numérique-analogique commandé par un deuxième code numérique de commande (B), le comparateur présentant une sortie de comparaison délivrant un signal de sortie présentant un retard souhaité par rapport au signal d'initialisation ; et

dans lequel, lors d'une phase d'utilisation du circuit de génération de retards, seul un code, dit code de sélection, parmi les premier et deuxième codes numériques de commande (A ; B) est utilisé pour sélectionner le retard souhaité, l'autre code de commande, dit code de réglage, restant à une valeur prédéfinie ; et

dans lequel, lors d'une phase de calibration du circuit de génération de retards, les premier et deuxième codes numériques de commande (A ; B) sont utilisés pour définir ladite valeur prédéfinie et la sortie de comparaison est reliée à une entrée d'un comparateur de phase ; et

dans lequel, le procédé de calibration comprend les étapes suivantes :

dans une première phase de test :

a1) appliquer un premier jeu de premier et deuxième codes numériques de commande et appliquer un signal d'initialisation ;
b1) délivrer, sur une autre entrée du comparateur de phase, un signal de calibration présentant un premier délai de référence (Ts) par rapport au signal d'initialisation ;
c1) analyser le signal de sortie de comparateur de phase ; et

dans une deuxième phase de test :

a2) appliquer un deuxième jeu de premier et deuxième codes numériques de commande et appliquer un signal d'initialisation ;
b2) délivrer, sur l'autre entrée du comparateur, un signal de calibration présentant un délai égal à la somme du premier délai de référence (Ts) et d'un deuxième délai de référence (Tref) ;
c2) analyser le signal de sortie du comparateur de phase.

**2.** Procédé selon la revendication 1, dans lequel les première et deuxième phases de test sont réitérées plusieurs fois en changeant les premier et deuxième jeux de premier et deuxième codes numériques de commande, pour identifier ladite valeur prédéfinie du code de réglage.

**3.** Procédé selon la revendication 1 ou 2, dans lequel la première phase de test est réitérée en changeant la valeur d'un même code parmi le code de sélection (B ; A) et le code de réglage (A ; B), et dans lequel la deuxième phase de test est réitérée en changeant la valeur de l'autre code.

**4.** Procédé selon l'une quelconque des revendications 1 à 3, dans lequel une même phase de test, la première et/ou la deuxième, est réitérée plusieurs fois pour un même jeu de codes numériques de commande, les valeurs successives du signal de sortie de comparaison étant analysées ensemble pour déterminer si le jeu de codes numériques appliqué permet ou non d'obtenir un délai de retard sensiblement égal, selon la phase de test, au premier délai de référence ou à la somme des premier et deuxième délais de référence.

**5.** Procédé selon la revendication 3, dans lequel, lors de la phase de test, réitérée en changeant la valeur du code de sélection (B ; A), on recherche une première valeur extrémale du code de sélection (Bc(s) ; Bc(e)) et dans lequel on définit une deuxième valeur extrémale du code de sélection (Bc(e) ; Bc(s)) à partir de la première valeur extrémale et d'un nombre de codes correspondant à une plage de codes de pleine échelle souhaitée (FSC) ; et dans lequel, lors de l'autre phase de test, réitérée en changeant la valeur du code de réglage (A ; B), la valeur du code de sélection utilisée correspond à la deuxième valeur extrémale du code de sélection préalablement définie.

6. Procédé selon l'une des revendications précédentes, dans lequel le deuxième délai de référence correspond à une pleine échelle de valeurs de délais souhaités pour lesquels la courbe représentant le délai de retard obtenu en fonction de la valeur de code de sélection, pour une valeur donnée de code de réglage, est sensiblement linéaire.

7. Procédé selon la revendication 1, utilisant un deuxième circuit de génération de retards identique audit circuit de génération de retards, dans lequel, lors des étapes b1) ou b2), le deuxième circuit de génération de retards est utilisé pour générer ledit signal de calibration en entrée du comparateur, le signal d'initialisation du deuxième circuit de génération de retards étant respectivement synchrone avec le signal d'initialisation du premier circuit de génération de retards ou différé d'un délai égal au deuxième délai de référence (Tref).

8. Circuit (1) comprenant un circuit de génération d'un retard, comportant :

- un élément capacitif (Cc) d'intégration d'un premier courant (I2) fourni par une première source de courant (7), dans lequel la première source de courant comporte un premier convertisseur numérique-analogique (8) commandé par un premier code numérique de commande (A) ;
- un circuit d'initialisation de l'élément capacitif sur commande d'un signal d'initialisation (RESET) ;
- un comparateur (12) d'une première tension (V14) de charge dudit élément capacitif (Cc) par rapport à une deuxième tension (V13), ladite deuxième tension étant générée à partir d'un deuxième convertisseur numérique-analogique commandé par un deuxième code numérique de commande (B), le comparateur présentant une sortie de comparaison délivrant un signal de sortie présentant un retard souhaité par rapport au signal d'initialisation ; et

dans lequel, lors d'une phase d'utilisation du circuit de génération de retards, seul un code, dit code de sélection, parmi les premier et deuxième codes numériques de commande (A ; B) est utilisé pour sélectionner le retard souhaité, l'autre code de commande, dit code de réglage, restant à une valeur prédéfinie ; et

dans lequel, lors d'une phase de calibration du circuit de génération de retards, les premier et deuxième codes numériques de commande (A ; B), ainsi que le signal d'initialisation, sont commandés par un dispositif de calibration, et le signal de sortie est reçu par le dispositif de calibration, afin de définir ladite valeur prédéfinie du code de réglage en mettant en oeuvre un procédé de calibration selon l'une des revendications 1 à 7.

9. Circuit selon la revendication 8, comprenant un circuit de calibration de retards relié au circuit de génération d'un retard, le circuit de calibration comprenant un comparateur de phase recevant sur une entrée ledit signal de sortie du circuit de génération d'un retard et sur une autre entrée un signal de calibration, le circuit de calibration mettant en oeuvre, dans une phase de calibration préalable à la phase d'utilisation, le procédé de calibration selon l'une des revendications 1 à 7.

10. Circuit selon la revendication 8 ou 9, dans lequel le deuxième délai de référence correspond à une période d'un signal d'horloge de référence.

11. Circuit selon la revendication 10, dans lequel le signal d'horloge de référence est généré par un dispositif de génération d'horloge du circuit.

12. Circuit selon la revendication 8, comprenant plusieurs circuits identiques de génération d'un retard, un deuxième circuit de génération d'un retard étant utilisé pour mettre en oeuvre le procédé de calibration sur un premier circuit de génération d'un retard, en mettant en oeuvre le procédé de calibration selon la revendication 7.

**Patentansprüche**

1. Verfahren zum Kalibrieren einer Verzögerungserzeugungsschaltung, wobei die Schaltung Folgendes aufweist:

ein kapazitives Element (Cc) zur Integration eines ersten Stroms (I2), der von einer ersten Stromquelle (7) geliefert wird, wobei die erste Stromquelle einen ersten Digital-Analog-Wandler (8) aufweist, der von einem ersten digitalen Steuercode (A) gesteuert wird;

eine Schaltung zur Initialisierung des kapazitiven Elements auf Befehl eines Initialisierungssignals (RESET) hin;
einen Komparator (12) einer ersten Ladespannung (V14) des kapazitiven Elements (Cc) bezüglich einer zweiten Spannung (V13), wobei die zweite Spannung von einem zweiten Digital-Analog-Wandler erzeugt wird, der von einem zweiten digitalen Steuercode (B) gesteuert wird, wobei der Komparator einen Vergleichsausgang aufweist, der ein Ausgangssignal mit einer gewünschten Verzögerung in Bezug auf das Initialisierungssignal liefert; und

wobei während einer Phase der Verwendung der Verzögerungserzeugungsschaltung nur ein Code, der Auswahlcode genannt wird, aus den ersten und zweiten digitalen Steuercodes (A; B) verwendet wird, um die gewünschte Verzögerung auszuwählen, wobei der andere Steuercode, der Einstellcode genannt wird, auf einem vordefinierten Wert verbleibt; und

wobei während einer Phase der Kalibrierung der Verzögerungserzeugungsschaltung die ersten und zweiten digitale Steuercodes (A; B) verwendet werden, um den vordefinierten Wert zu definieren, und der Vergleichsausgang mit einem Eingang eines Phasenkomparators gekoppelt wird; und

wobei das Kalibrierungsverfahren die folgenden Schritte aufweist:

in einer ersten Testphase:

a1) Anlegen eines ersten Satzes von ersten und zweiten digitalen Steuercodes und Anlegen eines Initialisierungssignals;
b1) Liefern, an einem anderen Eingang des Phasenkomparators, eines Kalibrierungssignals mit einer ersten Referenzverzögerung (Ts) bezüglich des Initialisierungssignals:
c1) Analysieren des Ausgangssignals des Phasenkomparators; und

in einer zweiten Testphase:

a2) Anlegen eines zweiten Satzes von ersten und zweiten digitalen Steuercodes und Anlegen eines Initialisierungssignals;
b2) Liefern, an den anderen Eingang des Komparators, eines Kalibrierungssignals mit einer Verzögerung, die gleich der Summe der ersten Referenzverzögerung (Ts) und einer zweiten Referenzverzögerung (Tref) ist;
c2) Analysieren des Ausgangssignals des Phasenkomparators.

2. Verfahren nach Anspruch 1, wobei die ersten und zweiten Testphasen mehrere Male wiederholt werden, wobei die ersten und zweiten Sätze der ersten und zweiten digitalen Steuercodes geändert werden, um den vordefinierten Wert des Einstellcodes zu identifizieren.

3. Verfahren nach Anspruch 1 oder 2, wobei die erste Testphase wiederholt wird, wobei der Wert eines gleichen Codes aus dem Auswahlcode (B; A) und dem Einstellcode (A; B) wiederholt wird, und wobei die zweite Testphase widerholt wird durch Ändern des Wertes des anderen Codes.

4. Verfahren nach einem der Ansprüche 1 bis 3, wobei eine gleiche Testphase, die erste und/oder die zweite, für einen gleichen Satz digitaler Steuercodes mehrfach wiederholt wird, wobei die aufeinanderfolgenden Werte des Ausgangsvergleichssignals zusammen analysiert werden, um zu bestimmen, ob der angewendete Satz digitaler Codes es ermöglicht oder nicht, eine Verzögerung zu erhalten, die gemäß der Testphase im Wesentlichen gleich der ersten Referenzverzögerung oder der Summe der ersten und zweiten Referenzverzögerung ist.

5. Verfahren nach Anspruch 3, wobei während der Testphase, die optional durch Ändern des Wertes des Auswahlcodes (B; A) wiederholt wird, ein erster Grenzwert des Auswahlcodes (Bc(s); Bc(e)) gesucht wird und wobei ein zweiter Grenzwert des Auswahlcodes (Bc(e); Bc(s)) aus dem ersten Grenzwert und aus einer Anzahl von Codes definiert wird, die einem gewünschten Vollschwingungscodebereich (FSC) entspricht; und wobei während der anderen Testphase, die optional durch Ändern des Wertes des Einstellcodes (A; B) wiederholt wird, der Wert des verwendeten Auswahlcodes dem zuvor definierten zweiten Grenzwert des Auswahlcodes entspricht.

6. Verfahren nach einem der vorhergehenden Ansprüche, wobei die zweite Referenzverzögerung einem gewünschten Vollschwingungsverzögerungsbereich entspricht, für den die Kurve, die die gemäß dem Auswahlcodewert erhaltene Verzögerung darstellt, für einen gegebenen Einstellcodewert im Wesentlichen linear ist.

7. Kalibrierungsverfahren nach Anspruch 1 unter Verwendung einer zweiten Verzögerungserzeugungsschaltung, die mit der Verzögerungserzeugungsschaltung identisch ist, wobei während der Schritte b1) und b2) die zweite Verzögerungserzeugungsschaltung verwendet wird, um das Kalibrierungssignal am Eingang des Komparators zu erzeugen, wobei das Initialisierungssignal der zweiten Verzögerungserzeugungsschaltung jeweils synchron mit dem Initialisierungssignal der ersten Verzögerungserzeugungsschaltung oder um eine Verzögerung gleich der zweiten Referenzverzögerung (Tref) verzögert ist.

8. Schaltung (1) mit einer Verzögerungserzeugungsschaltung, die Folgendes aufweist:

   ein kapazitives Element (Cc) zur Integration eines ersten Stroms (I2), der von einer ersten Stromquelle (7) geliefert wird, wobei die erste Stromquelle einen ersten Digital-Analog-Wandler (8) aufweist, der durch einen ersten digitalen Steuercode (A) gesteuert wird;
   eine Schaltung zur Initialisierung des kapazitiven Elements auf Befehl eines Initialisierungssignals (RESET) hin;
   einen Komparator (12) einer ersten Ladespannung (V14) des kapazitiven Elements (Cc) bezüglich einer zweiten Spannung (V13), wobei die zweite Spannung von einem zweiten Digital-Analog-Wandler erzeugt wird, der von einem zweiten digitalen Steuercode (B) gesteuert wird, wobei der Komparator einen Vergleichsausgang aufweist, der ein Ausgangssignal mit einer gewünschten Verzögerung bezüglich des Initialisierungssignals liefert; und
   wobei während einer Phase der Verwendung der Verzögerungserzeugungsschaltung nur ein Code, der Auswahlcode genannt wird, aus den ersten und zweiten digitalen Steuercodes (A; B) verwendet wird, um die gewünschte Verzögerung auszuwählen, wobei der andere Steuercode, der Einstellcode genannt wird, auf einem vordefinierten Wert verbleibt; und
   wobei während einer Phase der Kalibrierung der Verzögerungserzeugungsschaltung die ersten und zweiten digitalen Steuercodes (A; B) sowie das Initialisierungssignal von einer Kalibrierungsvorrichtung gesteuert werden und das Ausgangssignal von der Kalibrierungsvorrichtung empfangen wird, um den vordefinierten Wert des Einstellcodes durch Implementieren des Kalibrierungsverfahrens nach einem der Ansprüche 1 bis 7 zu definieren.

9. Schaltung nach Anspruch 8, die eine Verzögerungskalibrierungsschaltung aufweist, die mit der Verzögerungserzeugungsschaltung gekoppelt ist, wobei die Kalibrierungsschaltung einen Phasenkomparator aufweist, der an einem Eingang das Ausgangssignal der Verzögerungserzeugungsschaltung und an einem anderen Eingang ein Kalibrierungssignal empfängt, wobei die Kalibrierungsschaltung in einer Kalibrierungsphase vor der Gebrauchsphase das Kalibrierungsverfahren nach einem der Ansprüche 1 bis 7 implementiert.

10. Schaltung nach Anspruch 8 oder 9, wobei die zweite Referenzverzögerung einer Periode eines Referenztaktsignals entspricht.

11. Schaltung nach Anspruch 10, wobei das Referenztaktsignal von einer Takterzeugungsvorrichtung der Schaltung erzeugt wird.

12. Schaltung nach Anspruch 8, aufweisend eine Vielzahl identischer Verzögerungserzeugungsschaltungen, wobei eine zweite Verzögerungserzeugungsschaltung verwendet wird, um das Kalibrierungsverfahren einer ersten Verzögerungserzeugungsschaltung zu implementieren, indem das Kalibrierungsverfahren nach Anspruch 7 implementiert wird.

**Claims**

1. A method of calibrating a delay generation circuit, the circuit comprising:

   - a capacitive element (Cc) of integration of a first current (12) supplied by a first current source (7), wherein the first current source comprises a first digital-to-analog converter (8) controlled by a first digital control code (A);
   - a circuit of initialization of the capacitive element on order of an initialization signal (RESET);
   - a comparator (12) of a first charge voltage (V14) of said capacitive element (Cc) with respect to a second voltage (V13), said second voltage being generated from a second digital-to-analog converter controlled by a second digital control code (B), the comparator having a comparison output delivering an output signal having a desired delay with respect to the initialization signal; and

   wherein, during a phase of use of the delay generation circuit, only one code, called selection code, among the first and second digital control codes (A; B) is used to select the desired delay, the other control code, called adjustment code, remaining at a predefined value; and wherein, during a phase of calibration of the delay generation circuit, the first and second digital control codes (A; B) are used to defined said predefined value and the comparison output is coupled to an input of a phase comparator; and
wherein the calibration method comprises the steps of:

in a first test phase:

a1) applying a first set of first and second digital control codes and applying an initialization signal;
b1) delivering, on another input of the phase comparator, a calibration signal having a first reference delay (Ts) with respect to the initialization signal;
c1) analyzing the output signal of the phase comparator; and

in a second test phase:

a2) applying a second set of first and second digital control codes and applying an initialization signal;
b2) delivering, on said other input of the comparator, a calibration signal having a delay equal to the sum of the first reference delay (Ts) and of a second reference delay (Tref);
c2) analyzing the output signal of the phase comparator.

2. The method of claim 1, wherein the first and second test phases are repeated a plurality of times by changing the first and second sets of first and second digital control codes, to identify said predefined value of the adjustment code.

3. The method of claim 1 or 2, wherein the first test phase is repeated by changing the value of a same code from among the selection code (B; A) and the adjustment code (A; B), and wherein the second test phase is repeated by changing the value of the other code.

4. The method of any of claims 1 to 3, wherein a same test phase, the first and/or the second one, is repeated a plurality of times for a same set of digital control codes, the successive values of the output comparison signal being analyzed together to determine whether the applied set of digital codes enables or not to obtain a delay substantially equal, according to the test phase, to the first reference delay or to the sum of the first and second reference delays.

5. The method of claim 3, wherein, during the test phase, optionally repeated by changing the value of the selection code (B; A), a first limiting value of the selection code (Bc(s); Bc(e)) is searched for and wherein a second limiting value of the selection code (Bc(e); Bc(s)) is defined from the first limiting value and from a number of codes corresponding to a desired full swing code range (FSC); and wherein, during the other test phase, optionally repeated by changing the value of the adjustment code (A; B), the value of the selection code used corresponds to the previously-defined second limiting value of the selection code.

6. The method of any of the foregoing claims, wherein the second reference delay corresponds to a desired full swing delay range for which the curve representing the delay obtained according to the selection code value, for a given adjustment code value, is substantially linear.

7. The calibration method of claim 1, using a second delay generation circuit identical to said delay generation circuit, wherein, during steps b1) and b2), the second delay generation circuit is used to generate said calibration signal at the input of the comparator, the initialization signal of the second delay generation circuit being respectively synchronous with the initialization signal of the first delay generation circuit or delayed by a delay equal to the second reference delay (Tref).

8. A circuit (1) comprising a delay generation circuit, comprising:

- a capacitive element (Cc) of integration of a first current (12) supplied by a first current source (7), wherein the first current source comprises a first digital-to-analog converter (8) controlled by a first digital control code (A);
- a circuit of initialization of the capacitive element on order of an initialization signal (RESET);
- a comparator (12) of a first charge voltage (V14) of said capacitive element (Cc) with respect to a second voltage (V13), said second voltage being generated from a second digital-to-analog converter controlled by a second digital control code (B), the comparator having a comparison output delivering an output signal having a desired delay with respect to the initialization signal; and

wherein, during a phase of use of the delay generation circuit, only one code, called selection code, among the first and second digital control codes (A; B) is used to select the desired delay, the other control code, called adjustment code, remaining at a predefined value; and wherein, during a phase of calibration of the delay generation circuit, the first and second digital control codes (A; B), as well as the initialization signal, are controlled by a calibration device, and the output signal is received by the calibration device, to define said predefined value of the adjustment code by implementing the calibration method of any of claims 1 to 7.

9. The circuit of claim 8, comprising a delay calibration circuit coupled to the delay generation circuit, the calibration circuit comprising a phase comparator receiving on an input said output signal of the delay generation circuit and on another input a calibration signal, the calibration circuit implementing, in a calibration phase prior to the phase of use, the calibration method of any of claims 1 to 7.

10. The circuit of claim 8 or 9, wherein the second reference delay corresponds to a period of a reference clock signal.

11. The circuit of claim 10, wherein the reference clock signal is generated by a clock generation device of the circuit.

12. The circuit of claim 8, comprising a plurality of identical delay generation circuits, a second delay generation circuit being used to implement the calibration method on a first delay generation circuit, by implementing the calibration method of claim 7.

Fig 1

Fig 2A

Fig 2B

Fig 2C

Fig 3

Fig 4

EP 3 667 914 B1

Fig 5A

Fig 5B

Fig 6

EVr

EVc

OUTr    Ts

OUTc               Bc(s)-init                           Bc(s)-retenu

$\Rightarrow$

Fig 7A

EVc

EVr                Tref

OUTr                         Ts            Br(s)
                                                       avec Ac-init

OUTc                                              Bc(e)

$\Downarrow$

EVc

EVr

OUTr                                         Br(s)
                                                       avec Ac-retenu

OUTc                                              Bc(e)

Fig 7B

## RÉFÉRENCES CITÉES DANS LA DESCRIPTION

**Documents brevets cités dans la description**

- US 20160373120 A
- JP 04215314 A
- US 5790480 A
- US 20180269895 A